(19) Europäisches Patentamt

European Patent Office

Office européen des brevets

(11) **EP 4 632 681 A1**

(12) **EUROPEAN PATENT APPLICATION**

(43) Date of publication:
**15.10.2025 Bulletin 2025/42**

(21) Application number: **25163424.2**

(22) Date of filing: **13.03.2025**

(51) International Patent Classification (IPC):
**G06T 15/20** (2011.01) **G06T 17/00** (2006.01)

(52) Cooperative Patent Classification (CPC):
**G06T 17/00; G06T 15/20**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **10.04.2024 US 202418632022**

(71) Applicant: **The Boeing Company
Arlington, VA 22202 (US)**

(72) Inventors:
• **Gerwe, David Roderick
Arlington, 22202 (US)**
• **Okkelberg, Klaus Zhang
Arlington, 22202 (US)**
• **Gomez Hermosillo, Marisol
Arlington, 22202 (US)**

(74) Representative: **Witte, Weller & Partner
Patentanwälte mbB
Postfach 10 54 62
70047 Stuttgart (DE)**

(54) **SATELLITE MODEL GENERATION SYSTEM**

(57)　A method for satellite model generation includes generating a plurality of satellite generation values based on an input seed value. Using a satellite model generation system, a plurality of different three-dimensional (3D) satellite models are generated, wherein the plurality of different 3D satellite models differ according to a plurality of satellite configuration parameters, and wherein, for each 3D satellite model of the plurality of different 3D satellite models, the satellite configuration parameters of the 3D satellite model are determined based at least in part on the plurality of satellite generation values and a plurality of configuration plausibility constraints of the satellite model generation system. The plurality of different three-dimensional (3D) satellite models are output.

FIG. 2

EP 4 632 681 A1

## Description

FIELD

The invention relates generally to automatic generation of digital models, and more particularly, to the automatic generation of digital three-dimensional (3D) models of satellites.

BACKGROUND

Through computer software, digital three-dimensional (3D) models can be generated that serve as digital representations of physical objects. Such representations may specify the physical object's geometry, texture, color, material properties, and/or other suitable parameters. Model generation can be performed through several methods, including sculpting, where 3D models are individually crafted manually using specialized software, and photogrammetry, where 3D models are generated from a series of photographs of the physical object.

SUMMARY

This summary is not an extensive overview of the specification. It is intended to neither identify key or critical elements of the specification nor delineate any scope particular to embodiments of the specification, or any scope of the claims. Its sole purpose is to present some concepts of the specification in a simplified form as a prelude to the more detailed description that is presented in this disclosure.

A method for satellite model generation includes generating a plurality of satellite generation values based on an input seed value. Using a satellite model generation system, a plurality of different three-dimensional (3D) satellite models are generated, wherein the plurality of different 3D satellite models differ according to a plurality of satellite configuration parameters, and wherein, for each 3D satellite model of the plurality of different 3D satellite models, the satellite configuration parameters of the 3D satellite model are determined based at least in part on the plurality of satellite generation values and a plurality of configuration plausibility constraints of the satellite model generation system. The plurality of different three-dimensional (3D) satellite models are output.

The features, functions, and advantages that have been discussed can be achieved independently in various embodiments or can be combined in yet other embodiments, further details of which can be seen with reference to the following description and drawings.

BRIEF DESCRIPTION OF THE DRAWINGS

FIG. 1 schematically shows an example computing system used to implement a satellite model generation system.

FIG. 2 schematically illustrates generation of different three-dimensional (3D) satellite models based on satellite generation values.

FIGS. 3A-3C schematically illustrate different example 3D satellite models differing according to a plurality of satellite configuration parameters.

FIG. 4 schematically illustrates rendering satellite image views for a 3D satellite model via an image rendering system.

FIG. 5 schematically shows example satellite image views rendered to simulate visible-spectrum illumination light and infrared-spectrum illumination light.

FIG. 6 schematically illustrates outputting a configuration map labelling pixels in a satellite image view as corresponding to different satellite components.

FIG. 7 illustrates an example method for satellite model generation.

FIG. 8 schematically shows an example computing system.

DETAILED DESCRIPTION

Various techniques can be used to generate a digital three-dimensional (3D) model that serves as a digital representation of a corresponding physical object. However, present technology is incapable of programmatically generating high volumes (tens or hundreds of thousands) of hypothetical digital 3D models of a class of objects, such as satellites, where such models embody a wide and random variety of configurations, and where all such configurations are reasonably realistic and plausible configurations of an object in the class. Further, some model generation technologies are limited to generating digital 3D models corresponding to existing physical objects that can be photographed in the real world, and cannot programmatically generate digital 3D models of hypothetical objects from a class of objects.

Accordingly, the present disclosure is directed to techniques for automatically generating digital 3D models. In particular, the present disclosure describes a satellite model generation system used to generate digital 3D models representing satellites, referred to herein as "3D satellite models." The satellite model generation system receives a set of satellite generation values having been generated based on an input seed (e.g., using a pseudo-random number generator (PRNG)), and then generates a plurality of 3D satellite models based on the satellite generation values. The generated 3D satellite models differ according to a plurality of different satellite configuration parameters, which are determined both by the satellite generation values and a plurality of configuration plausibility constraints of the satellite generation model. Furthermore, the 3D satellite models generated by the satellite model generation system need not be limited only to real-world satellites, but rather can represent hypothetical satellite configurations that have not actually been constructed in the real world.

In this manner, the techniques described herein can beneficially be used to rapidly generate a vast quantity of digital 3D models corresponding to plausible hypothetical satellite configurations. Furthermore, the 3D satellite models generated as described herein can be used to render a plurality of different image views for each satellite configuration. While rendering image views, various rendering settings may be programmatically changed between each image view. This can be done, for instance, to change the apparent pose of the satellite in the image view, change illumination lighting conditions (e.g., light intensity, direction, wavelength spectrum), change an apparent image backdrop, etc., thereby generating a diverse set of images depicting each different 3D satellite model, with such images containing a huge range of variability in satellite geometric configuration and appearance. In this manner and as described further below, the techniques described herein can generate, in some examples, hundreds of thousands of images of random and realistic satellites in one hour or less. These images can, for instance, be used to train a machine learning (ML) model used to classify different components of unknown satellites, and/or for any other suitable purpose.

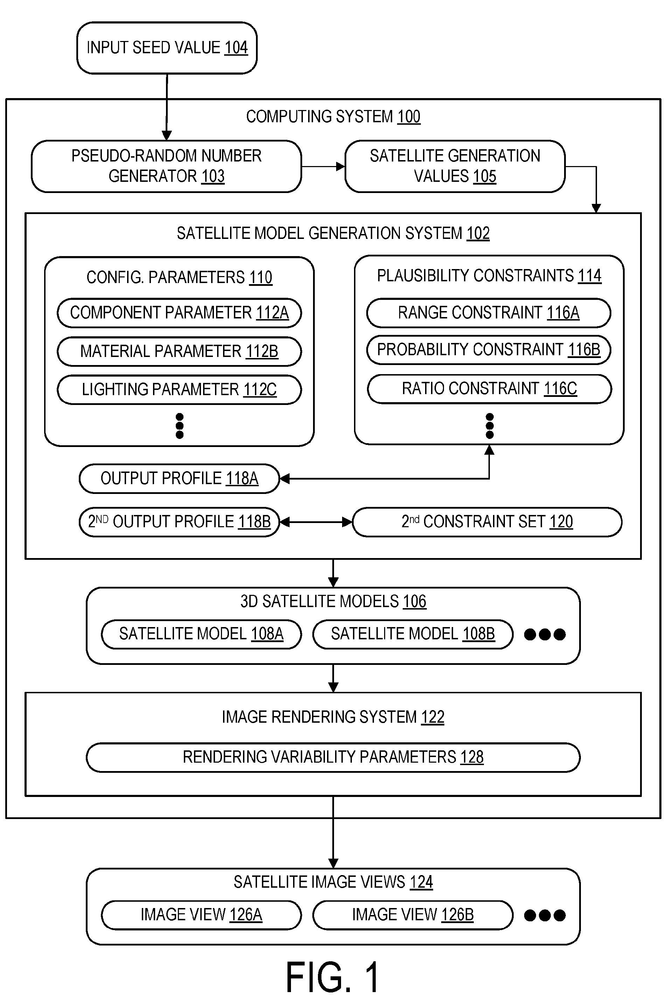

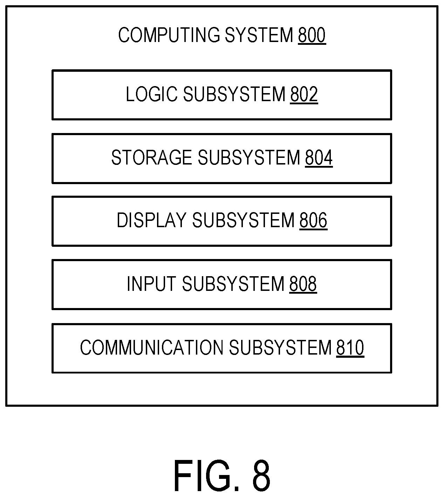

FIG. 1 schematically shows an example computing system 100 used to implement any or all of the satellite model generation techniques described herein. Computing system 100 may be implemented via any suitable combination of computer hardware components. As one example, computing system 100 may take the form of a server computer. In other examples, the computing device may take another suitable form, such as a personal computer. In some examples, aspects of computing system 100 may be distributed between two or more different computing devices. In general, computing system 100, as well as the other computing devices described herein, has any suitable capabilities, hardware configuration, and form factor. Any or all of the computing devices described herein, including computing system 100, may in some cases be implemented as computing system 800 described below with respect to FIG. 8.

As shown in FIG. 1, computing system 100 is used to implement a satellite model generation system 102. The satellite model generation system is implemented as any suitable combination of computer software, hardware, and/or firmware components usable to generate digital 3D models representing satellites. In some examples, the satellite model generation system is implemented through suitable machine learning (ML) and/or artificial intelligence (AI) techniques. As non-limiting examples, the satellite model generation system may include a generative adversarial network (GAN), variational autoencoder (VAE), convolutional neural network (CNN), transformer model, and/or any other suitable trained ML model.

In general, generation of satellite models involves making a series of decisions about the satellite's configuration, such as the shape, dimensions, and surface properties of its parts, the position and orientation of its parts relative to each other, the satellite's overall orientation, and/or the external lighting environment. To randomize the configuration, these decisions may be made based on randomized satellite generation values - e.g., output by a random number generator (RNG) or pseudo-random number generator (PRNG). In one example scenario, the shape of the satellite body could be selected to have a 40% chance of being a box, 35% cylinder, and 25% hexagonal prism. A random satellite generation value X may be generated between zero and one hundred, and the body shape may be picked based on its value, such that:

$$0 \leq X < 40 = \text{box}$$

$$40 \leq X < 75 = \text{cylinder}$$

$$75 \leq X \leq 100 = \text{hexagonal pyramid}$$

As another example, the length of the satellite body may be randomly selected to equal a satellite generation value produced by a random number generator that is configured to randomly output values from a uniform distribution on a continuum from 0.5 meters to 2 meters. Alternatively, non-uniform distributions can also be used that could, for instance, also lie within a range, but more heavily weight the outcome to values near the lower end, middle, or upper end.

RNGs can be implemented in any suitable way. In some examples, RNGs may be driven by measurements of some random physical noise process (e.g., voltage fluctuations, thermal kinetic motion of atoms, polarization states of thermally emitted photons, etc.). By contrast, PRNGs are algorithms for generating long sequences of numbers that follow some probabilistic distribution. The present disclosure refers to the values output by an RNG and/or PRNG, and used for satellite model generation, as satellite generation values. In some examples, the specific sequence of values generated by a PRNG is determined by an input seed value provided to the PRNG, such that the PRNG will reproduce the same series of satellite generation values if it is initiated with the same input seed value. Different input seed values will, when provided to a PRNG, produce different sets of satellite generation values that are highly uncorrelated, and thus will result in different satellite models. The input seed values provided to a PRNG can be selected by hand, set to fixed values, and/or randomly selected such as based on a measurement of a random process (e.g., stock price, wind speed, voltage, last key press on a computer, current fraction of a second on a computer's clock, etc.).

Use of PRNGs can beneficially provide flexibility in separately controlling the randomness of different aspects of satellite model generation. Such aspects may include, for example, the satellite's (a) geometric configuration, (b) surface reflectivity, (c) surface textures, (d) overall orientation, and/or (e) directions of external illumination sources. In some examples, a different PRNG and input seed value can be used for each of each different aspect (a) - (e). Thus, for example, if 100 random satellites are generated, each using the same input seed values for the PRNGs associated with (a), (d), and (e) but different input seeds for the PRNGs for (b) and (c), each instance of the 100 satellites would have the same geometric configuration, orientation, and lighting, but different surface reflectivities and textures. In the series of decisions about a set of attributes of the satellite, the PRNGs can be re-initiated between satellites or continued for the full set of decisions for a sequence of satellites.

In the example of FIG. 1, computing system 100 implements a PRNG 103. The PRNG receives an input seed value and generates a plurality of satellite generation values 105, which are input to the satellite model generation system. As will be described in more detail below, the satellite model generation system is configured to generate 3D satellite models based at least in part on the set of satellite generation values. In some examples, satellite model generation is deterministic, such that the same set of satellite generation values will always result in generation of the same set of 3D satellite models by the satellite model generation system. In other examples, satellite model generation may be non-deterministic, such that the same set of satellite generation values provided to the satellite model generation system at different times will result in generation of different sets of output satellite models.

The satellite generation values take any suitable form. For instance, the satellite generation values may range from 0-1, 1-10, 1-100, or have any other suitable range. In some examples, the satellite generation values are generated by a PRNG, as is shown in FIG. 1. In such cases, the PRNG may be integrated into, or external from, the computing system that implements the satellite model generation system. In general, the satellite generation values, and/or the input seed value used to generate the satellite generation values, may be loaded from computer storage, received over a computer network, generated by the computing system, and/or have any other suitable source.

In some examples, the input seed value used to generate the satellite generation values may be stored, such that it can later be provided to a deterministic PRNG to recreate a given set of satellite generation values. This can beneficially enable conservation of computer storage space - e.g., alleviating the need to use potentially large amounts of storage space to store 3D satellite models, when the models can instead be recreated from a stored input seed value.

After receiving the satellite generation values, the satellite model generation system 102 generates a set of 3D satellite models 106. In the example of FIG. 1, these include at least 3D satellite model 108A and satellite model 108B. As used herein, a "3D satellite model" takes the form of any suitable data structure representing the 3D geometry of a satellite. In some examples, a 3D satellite model may additionally specify the satellite's texture, color, material properties, and/or other suitable properties. A 3D satellite model may be formatted and encoded in any suitable way.

The satellite model generation system may generate any suitable number of different 3D satellite models. Although two 3D satellite models are generated in FIG. 1, this is non-limiting. In other examples, the satellite model generation system may generate only one 3D satellite model per pass, or more than two 3D satellite models per pass. For instance, the satellite model generation system may in some cases be used to generate hundreds, thousands, or more unique 3D satellite models per pass.

As used herein, a "satellite" generally refers to a spacecraft designed to orbit the Earth and/or another celestial body. A satellite may include any number of individual components. In general, satellites may have one or more of many types of parts including, as non-limiting examples, solar panels, antennas, radiators, star-trackers, thrusters, docking systems, mounting systems, windows, external markings, and/or sensors, such as electro-optic, radar, magnetometers, particle detectors, etc. Each of these parts can themselves come in a variety of geometric configurations, and have a variety of surface properties including reflective, texture, and thermal properties. The parts may be located relative to the body in a variety of positions and orientations. Further, in rendering an image of the satellite model, the model can be in a continuum of positions and orientations relative to the camera, and the model may be illuminated by one or more light sources each having its own position, brightness and spectrum. Light sources may range from highly directional, to diffuse and uniform. It will be understood that, in some cases, the techniques described herein may be applied to non-orbital spacecraft designed for deep space, travel from one celestial body to another, and/or any other suitable purpose.

The plurality of 3D satellite models 106 generated by the satellite model generation system 102 differ according to a plurality of satellite configuration parameters 110. A "satellite configuration parameter" may include any suitable variable that, when changed, affects the configuration and/or appearance of an output 3D satellite model as compared to other satellite models having different values of the variable. The values for each satellite configuration parameter 110 are determined based at least in part on the satellite generation values 104. In other words, for a given satellite configuration parameter, the value for that parameter may be determined at least in part by a corresponding satellite generation value from the set of satellite generation values. In this manner, satellite configuration parameters for each output 3D satellite model may be at least somewhat randomized (e.g., through randomized satellite generation values), resulting in a diverse set of different satellite configurations being generated.

As discussed above, the satellite model generation system may be implemented as any suitable combination of computer software, hardware, and/or firmware. In some examples, the software generation system is implemented as one or more software applications configured to generate 3D satellite models based on satellite generation values and based on a predefined set of configuration parameters and configuration plausibility constraints. The configuration parameters and plausibility constraints may, for instance, be stored in a configuration file that is read by the software application.

Additionally, or alternatively, the satellite model generation system may be implemented through suitable ML and/or AI techniques. In such cases, the satellite model generation system may be trained to output 3D satellite models in any suitable way. As one non-limiting example, the satellite model generation system may be trained based on a dataset of training 3D satellite models (e.g., generated through sculpting or another suitable method), each having known satellite configuration parameters. During training, the satellite model generation system may be provided with the known satellite configuration parameters, with the aim of recreating the training 3D satellite models. Over a plurality of training passes, the difference between the training 3D satellite models and the 3D satellite models output by the satellite model generation system may be iteratively reduced. In this manner, the satellite model generation system may be trained to produce novel 3D satellite models when provided with novel satellite generation values.

The satellite model generation system may receive any suitable number of satellite generation values. In some examples, the number of satellite generation values may be equal to, or greater than, the number of satellite configuration parameters supported by the satellite model generation system. For instance, each different satellite generation value may be used to determine a corresponding satellite configuration parameter, as will be described in more detail below. In cases where multiple 3D satellite models are generated at once, then the satellite generation values may be divided into different sets of satellite generation values for each different 3D satellite model.

As discussed above, the satellite generation values may have any suitable range. Furthermore, the satellite configuration parameters may each have any suitable range of acceptable values, depending on the implementation and on the purpose of the satellite configuration parameter. Thus, it will be understood that the satellite generation values may be mapped or normalized to corresponding satellite configuration parameters in any suitable way. In one simplified example, a given satellite configuration parameter may only have two possible values, and the satellite generation values may range from 1-100. In this case, a satellite generation value of less than or equal to 50 may cause the satellite configuration parameter to have one value (e.g., zero), while a satellite generation value of greater than 50 may cause the satellite configuration parameter to have another value (e.g., one). It will be understood that this is only one simplified example, and that the value for a satellite configuration parameter may be determined in any suitable way, based on the satellite generation value for that parameter and any configuration plausibility constraints affecting that parameter.

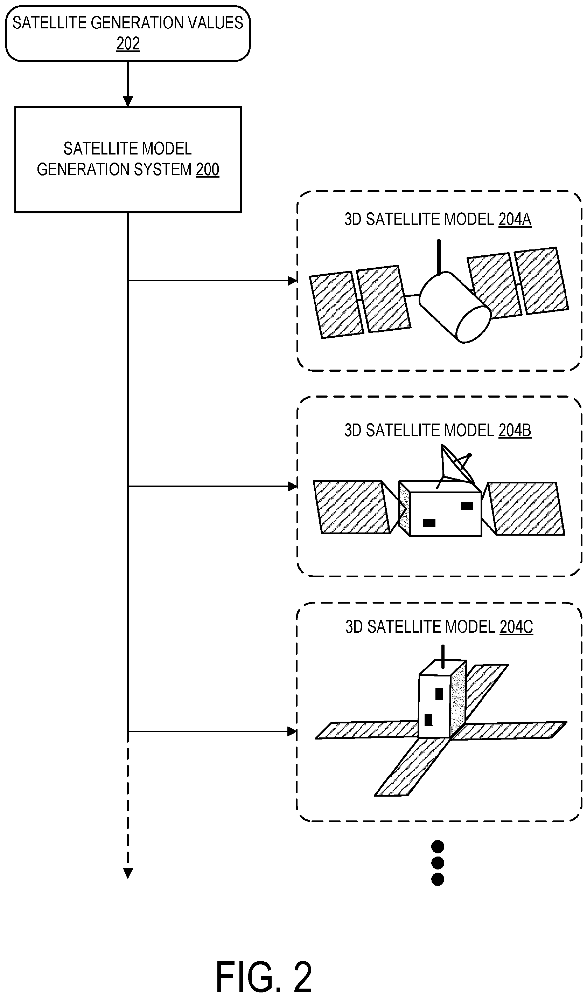

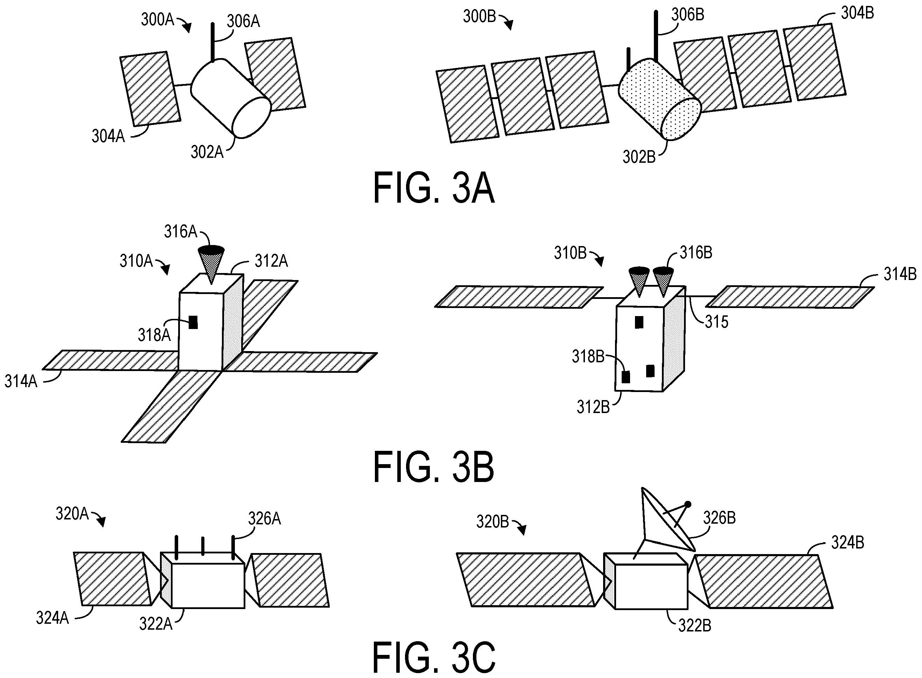

In some examples, the plurality of satellite configuration parameters include one or more satellite component parameters. In the example of FIG. 1, the set of satellite configuration parameters 110 includes at least one component parameter 112A. A "satellite component parameter" may define the geometry, placement, and/or type of a satellite component included in the 3D satellite model. As examples, a satellite component parameter may be selected from a shape of a satellite body of the 3D satellite model (e.g., cylindrical, box-shaped, hexagonal), a quantity of solar panels for the 3D satellite model, a quantity of antennas for the 3D satellite model, a quantity of thrusters for the 3D satellite model, dimensions for one or more satellite components in the 3D satellite model (e.g., dimensions of the satellite body, size and/or shape of satellite antennas, size and/or shape of satellite thrusters), a component type for the one or more satellite components in the 3D satellite model (e.g., rod antenna or dish antenna), an attachment type for the one or more satellite components in the 3D satellite model (e.g., rigidly attached to the satellite body, attached to the satellite body by way of a supporting member), and/or attachment locations for one or more of the satellite components in the 3D satellite model (e.g., attachment coordinates relative to the satellite body, or relative to another satellite component). Example 3D satellite models varying according to these satellite component parameters will be described below with respect to FIG. 2 and FIGS. 3A-C.

In some examples, the satellite configuration parameters include one or more satellite material parameters. In the example of FIG. 1, satellite configuration parameters 110 include at least one material parameter 112B. As examples, a satellite material parameter may define, for a simulated material in a 3D satellite model, reflectivity properties of the simulated material, brightness properties of the simulated material, and/or thermal properties of the simulated material. Reflective properties can range in complexity from Lambertian, to a full complex Bidirectional Reflectance Distribution Function (BRDF), which species the amount of light reflected in each direction from a surface as dependent on the direction of the illumination.

In some examples, the satellite configuration parameters include one or more satellite lighting parameters. For instance, in FIG. 1, the satellite configuration parameters 110 include at least one lighting parameter 112C. As examples, a satellite lighting parameter may be selected from a position of a light source relative to the 3D satellite model, an intensity of illumination light provided by the light source, and a uniformity of the illumination light on the 3D satellite model. Light sources can range from highly directional to completely diffuse, e.g. uniform from every direction. In this example, the satellite lighting parameters are defined during generation of 3D satellite models. It will be understood that, in some cases, lighting parameters may additionally or alternatively be controlled when rendering image views for a 3D satellite model.

Satellite configuration parameters may in some cases be "discrete-type" parameters - e.g., having a limited number of individual permissible values. This may include, for example, a parameter defining the satellite body shape (e.g., box, cylinder, hexagon), or a parameter defining the number of solar panels (e.g., 1, 2, 4). By contrast, "continuous-type" parameters may accept a range of permissible values - e.g., length of a component, placement of a component. In some examples, satellite configuration parameters may be associated with a decision tree. For instance, at each branch in the tree, a decision may be made that affects the downstream parameters for the satellite configuration - e.g., upon determining that the satellite has a cylindrical body, a subsequent node in the decision tree may determine the radius of the cylinder.

The satellite configuration parameters of each 3D satellite model are determined based at least in part on the satellite generation values and a plurality of configuration plausibility constraints of the satellite model generation system. For instance, in FIG. 1, the satellite model generation system includes a plurality of configuration plausibility constraints 114. In general, these configuration plausibility constraints serve to influence or limit the values assigned to one or more of the satellite configuration parameters.

For instance, a particular plausibility constraint may define a range of permissible values for a corresponding satellite configuration parameter. In FIG. 1, the configuration plausibility constraints include a range constraint 116A. In one non-limiting example scenario, a range-type plausibility constraint may specify that a satellite should have no fewer than two solar panels and no more than ten solar panels. In other words, the plausibility constraint limits a corresponding panel quantity configuration parameter to values ranging between two and ten. Thus, in setting the panel quantity configuration parameter for each 3D satellite model, a satellite generation value may be normalized to between two and ten, and then used as the number of solar panels to be included in the 3D satellite model.

In some examples, at least one configuration plausibility constraint of the plurality of configuration plausibility constraints defines, for a satellite configuration parameter of the plurality of satellite configuration parameters, a probability distribution of values for the satellite configuration parameter. In the example of FIG. 1, the satellite plausibility constraints include at least one probability constraint 116B. A probability constraint may define certain values of a corresponding satellite configuration as being relatively more probable, with other values being relatively less probable. In one example scenario, a probability-type constraint may specify that the number of antennas included in a satellite configuration (as defined by a corresponding antenna quantity configuration parameter) is most likely to be one, with increasingly low probability as the quantity increases. For instance, a value of one may have a 50% probability, a value of two may have a 30% probability, a value of three may have a 10% probability, and so on.

In some examples at least one configuration plausibility constraint of the plurality of configuration plausibility constraints defines, for a satellite configuration parameter of the plurality of satellite configuration parameters, a maximum ratio difference between the satellite configuration parameter and a second satellite configuration parameter. In FIG. 1, configuration plausibility constraints 112 include at least one ratio constraint 116C. In one example scenario, one satellite configuration parameter may specify the length of the satellite body, while another satellite configuration parameter may specify the width of the satellite body. Thus, a ratio-type constraint may, for instance, specify that the satellite length cannot be more than three times greater than the satellite width. Such ratio constraints can be used to control the level of variety of satellite geometric configurations - e.g., to avoid highly implausible shapes and/or to restrict the geometries to a highly limited range.

It will be understood that the satellite plausibility constraints described above are non-limiting examples. In general, the permissible values for the satellite configuration parameters may be defined or limited in any suitable way, via any suitable set of configuration plausibility constraints. Furthermore, in some examples, the satellite model generation system may maintain two or more different sets of configuration plausibility constraints, which can be switched between depending on the desired types of 3D satellite models to be generated. For instance, in the example of FIG. 1, the configuration plausibility constraints 114 are associated with a first satellite output profile 118A, and the satellite model generation system 102 is switchable between output profile 118A and a second satellite output profile 118B associated with a second different plurality of configuration plausibility constraints 120. This may, for instance, enable a human worker and/or automated system some ability to control the types of 3D satellite models output by the satellite model generation system.

In one example scenario, one output profile may be used to generate models representing large communication satellites. When this output profile is selected, the satellite model generation system may use a set of configuration plausibility constraints that favor satellites having larger body sizes, having a higher number of antennas, having relatively larger antennas, having relatively more solar panels, etc. By contrast, another output profile may be used to generate models representing smaller satellites - e.g., picosatellites. When this output profile is selected, the satellite model generation system may use a set of configuration plausibility constraints that favor satellites having smaller body sizes, fewer solar panels, fewer and smaller antennas, etc. It will be understood that these output profile examples are simplified and non-limiting, and that an output profile may be associated with any arbitrary collection of configuration plausibility constraints to influence the types of 3D satellite models output by the satellite model generation system.

The generation of 3D satellite models is schematically illustrated with respect to FIG 2. Specifically, FIG. 2 schematically shows an example satellite model generation system 200. A plurality of satellite generation values 202 are input to the satellite model generation system, resulting in the output of several 3D satellite models, including models 204A, 204B, and 204C. These 3D satellite models vary according to a plurality of satellite configuration parameters, as discussed above. It will be understood that the specific 3D satellite models shown in FIG. 2, as well as FIGS. 3A-5 described below, are non-limiting, highly simplified, and provided only for the sake of explanation.

FIGS. 3A-C schematically show additional examples of 3D satellite models to illustrate potential variance relative to several satellite configuration parameters. FIG. 3A shows two different 3D satellite models 300A and 300B. Each of these 3D satellite models comprise various subcomponents, including a satellite body 302A/B, solar panels 304A/B, and antennas 306A/B. It will be understood that the 3D satellite models described herein may be assembled from any of a wide variety of subcomponents, and that the specific subcomponents discussed herein are non-limiting. Rather, the techniques described herein are applicable to a wide variety of different types of satellite configurations, including additional or alternative subcomponents to those described herein.

With respect to FIG. 3A, while the satellite bodies for 3D satellite models 300A and 300B are the same shape (e.g., a cylindrical shape), 3D satellite model 300B uses a different simulated material for the satellite body. This is indicated by the fill pattern used for satellite body 302B. As discussed above, this may be determined by a satellite material parameter of the plurality of satellite configuration parameters. Similarly, 3D satellite model 300A includes two solar panels, while 3D satellite model 300B includes six solar panels. 3D satellite model 300A includes one antenna 306A, while 3D satellite model 300B includes two different antennas, having different sizes relative to one another and relative to the antenna of 3D satellite model 300A. Each of these differences may correspond to different values for the satellite configuration parameters described above, as determined by the satellite generation values and configuration plausibility constraints.

FIG. 3B schematically shows additional examples of 3D satellite models 310A and 310B. These 3D satellite models each include respective satellite bodies 312A/B, which in this example take the form of rectangular boxes. Satellite model 310A includes a total of four solar panels 314A, which are each attached to a lower edge of the satellite body (relative to the page). By contrast, satellite model 310B includes a total of two solar panels 314B, which are attached to an upper side of the satellite body. Furthermore, the manner of solar panel attachment differs between the two satellite models. In the case of 3D satellite model 310A, the solar panels are rigidly affixed directly to the satellite body. In the case of satellite 310B, the solar panels are attached to the satellite body via a supporting member 315, which may take any suitable form (e.g., trusses, beams, brackets, couplers). Attachments may be rigid, swiveling, hinged, etc.

In FIG. 3B, 3D satellite model 310A includes a thruster 316A, which is depicted as a cone in this simplified representation. A satellite may include any suitable number and variety of thrusters. As non-limiting examples, a satellite may include one or more chemical thrusters, electric propulsion thrusters, cold gas thrusters, etc. Satellite model 310B includes two thrusters 316B, which each have a smaller size as compared to thruster 316A of satellite 310A. It will be understood that, while satellites 300A and 300B include antennas and satellites 310A and 310B include thrusters, this does not mean that antennas and thrusters are mutually exclusive. Rather, 3D satellite models generated according to the techniques described herein may include any suitable number and variety of antennas, thrusters, and/or other satellite components.

Furthermore, in FIG. 3B, 3D satellite model 310A includes a generic component representation 318A. A "generic component representation" serves as a representation of any arbitrary component or visible feature on a satellite body, and/or other portion of a 3D satellite model. As non-limiting examples, generic component representations may serve to represent sensors, cameras, thruster nozzles, access panels, connectors, status indicators (e.g., lights), magnetorquers, fasteners (e.g., bolts, rivets, screws), and/or other suitable components. Within a 3D satellite model, generic component representations may have any suitable size, shape, and placement relative to the satellite.

In FIG. 3B, generic component representation 318A takes the form of a small rectangle, although it will be understood that other shapes (e.g., circles, ovals, squares, other polygons, irregular shapes) may additionally or alternatively be used. Furthermore, a 3D satellite model may include any suitable number and variety of generic component representations. For instance, 3D satellite model 310B includes three generic component representations, one of which is labeled as representation 318B. As with other aspects of the 3D satellite models, the appearance and/or placement of generic component representations may be specified by satellite configuration parameters. In other words, in some examples, the satellite configuration parameters include, for each of one or more generic component representations attached to a satellite body in the 3D satellite model, an appearance of the generic component representation and a position of the generic component representation.

FIG. 3C schematically shows additional examples of 3D satellite models 320A and 320B. These 3D satellite models each include respective satellite bodies 322A/B, which in this example take the form of rectangular boxes. However, the dimensions of satellite bodies 322A and 322B differ as compared to satellite bodies 312A and 312B of FIG. 3B. Satellite model 320A includes a total of two solar panels, one of which is labeled as solar panel 324A. Satellite model 320B similarly includes two solar panels, one of which is labeled as solar panel 324B. However, the solar panels for 3D satellite model 320B are larger than the solar panels for 3D satellite model 320A.

Satellite model 320A includes a total of three antennas, one of which is labeled as antenna 326A. By contrast, 3D satellite model 320B includes a single dish-type antenna 326B. As discussed above, the size, placement, and type of antennas used may vary from one 3D satellite model to another, as specified by the satellite configuration parameters. As non-limiting examples, satellite antennas may include parabolic dish antennas, patch antennas, helical antennas, horn antennas, phased array antennas, etc.

It will be understood that the potential differences described above between different 3D satellite models are non-limiting. Rather, two different 3D satellite models generated according to the techniques described herein may vary according to any suitable number and variety of different satellite configuration parameters. Additional non-limiting examples of satellite configuration parameters will now be provided:

- Body shape (e.g., box, cylinder, hexagon)
- Body size
- Body scaling value
- Body surface reflectivity
- Satellite front purpose (e.g., communications antenna, imaging, communications dishes, geosynchronous communications)
- Solar panels quantity
- Solar panel segments quantity (e.g., in cases where a single panel includes two or more segments attached together)
- Solar panel size relative to satellite body
- Solar panel reflectivity
- Solar panel rotation relative to satellite body
- Solar panel attachment type
- Antenna type
- Antenna size (e.g., length, width, dish radius, dish curvature, dish rotation)

- Antenna reflectivity
- Sensor payload quantity
- Sensor types and configurations (e.g., electro-optic, radar, radio frequency, magnetometers, particle detectors)
- Imaging lens size
- Thruster type
- Thruster size
- Component attachment positions

Once the 3D satellite models are generated by the satellite model generation system, they are output. It will be understood that a 3D satellite model may be "output" in various suitable ways depending on the implementation. In some embodiments, outputting the 3D satellite model includes passing the 3D satellite model to a downstream application (e.g., for rendering as image views), transmitting the 3D satellite model to another computing device, writing the 3D satellite model to a data file, storing the 3D satellite model in non-volatile storage of the computing device, and/or storing the 3D satellite model in an external storage device communicatively coupled with the computing device.

As discussed above, once 3D satellite models are generated, they may in some cases be input to an image rendering system used to render a plurality of image views of the plurality of different 3D satellite models. Returning briefly to FIG. 1, once generated by the satellite model generation system 102, the 3D satellite models are input to an image rendering system 122. The image rendering system renders a plurality of satellite image views 124, including image views 126A and 126B. These take the form of individual images depicting the 3D satellite models rendered by the satellite model generation system.

The image rendering system may take the form of any suitable combination of computer software, hardware, and/or firmware usable to render 2D image views based on input 3D models. In general, image rendering may include projecting the 3D model onto a 2D plane, simulating lighting effects based on specified settings and simulated material properties, and then outputting a 2D image based on rasterization and/or ray tracing of simulated lighting effects on the 3D model.

In the example of FIG. 1, the satellite model generation system and image rendering system are depicted as being separate systems each implemented by the same computing system 100. However, it will be understood that this is non-limiting. For instance, in some examples, the satellite model generation system and image rendering system may be implemented via different computing devices that are communicatively coupled with one another - e.g., 3D satellite models generated by one computing device may be transmitted to another computing device for image rendering. Alternatively, the satellite model generation system and image rendering system may in some cases be implemented together as a single software model - e.g., configured to receive satellite generation values and then generate a plurality of rendered image views depicting different generated 3D satellite models.

Although two different satellite image views are rendered in FIG. 1, this is non-limiting. Rather, any suitable number of different satellite image views may be rendered in total, which may include any suitable number of different satellite image views depicting each generated 3D satellite model. In some cases, two or more different satellite image views may be rendered that each depict the same 3D satellite model. In some cases, some 3D satellite models may be generated for which no satellite image views are rendered. Each individual satellite image view may have any suitable image properties, such as resolution, encoding, image type (e.g., color image, black-and-white, grayscale), etc.

In some examples, each of the plurality of different satellite image views differ according to one or more rendering variability parameters. This is the case in FIG. 1, where the image rendering system 122 renders the satellite image views 124 such that they differ according to a plurality of rendering variability parameters 128. As non-limiting examples, the rendering variability parameters may include, for each satellite image view, a pose of a 3D satellite model within the satellite image view (e.g., a six degree-of-freedom pose specifying the 3D position and orientation of the satellite), a distance of the 3D satellite model from a virtual camera position, and a backdrop scene in the satellite image view.

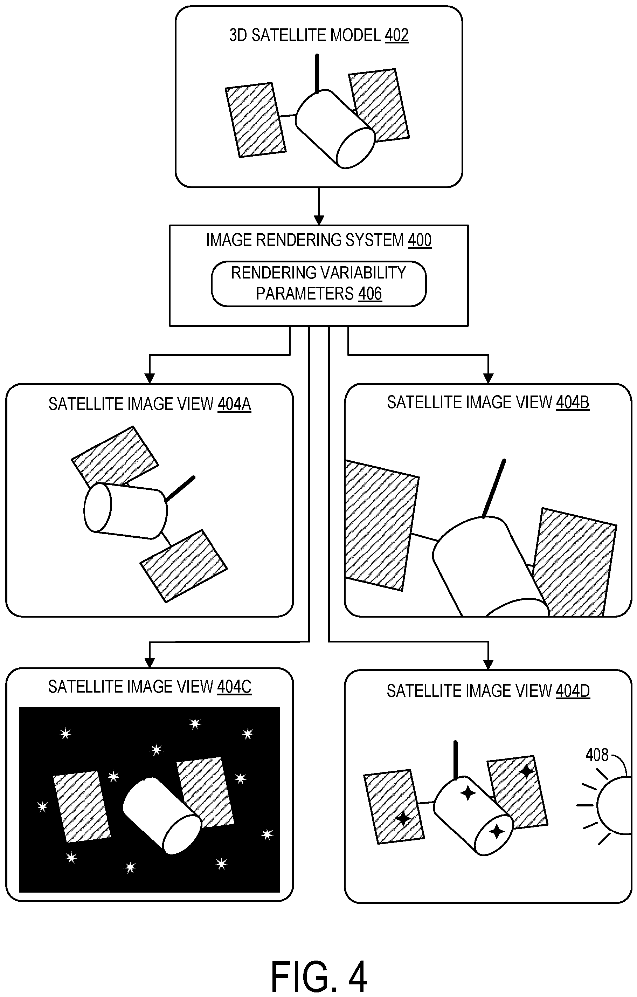

Satellite image view rendering is schematically illustrated in more detail with respect to FIG. 4. Specifically, FIG. 4 schematically shows another example image rendering system 400, which receives a 3D satellite model 402. The image rendering system outputs a plurality of satellite image views 404A-404D. While four different satellite image views are rendered in FIG. 4, this is a non-limiting example. Each of these satellite image views depicts the 3D satellite model 402.

However, in FIG. 4, the different satellite image views differ in various ways, according to rendering variability parameters 406 of the image rendering system. With respect to satellite image views 404A and 404B, the pose of the 3D satellite model within each satellite image view is different. For instance, in satellite image view 404B, the pose of the 3D satellite model is rotated relative to the perspective of satellite image view 404B. Furthermore, in satellite image view 404B, the 3D satellite model is relatively closer to a virtual camera position.

In satellite image view 404C, a backdrop scene behind the 3D satellite model has been changed. Specifically, as compared to the other satellite image views of FIG. 4, image view 404C includes a black backdrop with stars. In general, a satellite image view may have any suitable backdrop, such as a blank backdrop, a solid color backdrop (e.g., black, grey, green), a backdrop that resembles a typical operating environment for a satellite (e.g., an outer space view with stars, planets, and/or other objects visible), etc.

In satellite image view 404D, simulated lighting conditions in the satellite image view have been changed. Specifically, in this image view, a simulated illumination light source 408 (e.g., the sun) is emitting illumination light toward the 3D satellite model. While in this example, the illumination light source itself is visible in the satellite image view, it will be understood that this is only done for the sake of explanation and need not be the case. As discussed above, simulated lighting conditions may be varied during 3D satellite model generation and/or image view rendering. This may include changing the position of the illumination light source, the direction of the illumination light, the intensity of the illumination light, a wavelength spectrum for the illumination light, etc.

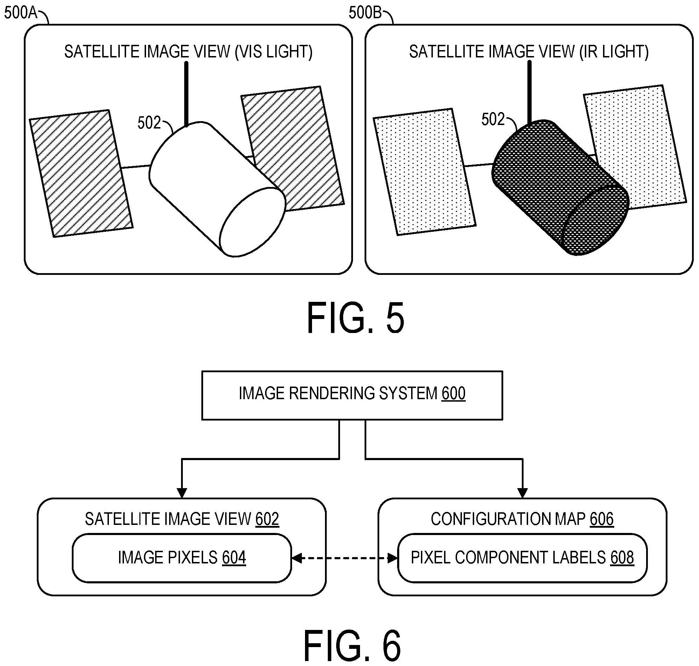

FIG. 5 schematically shows additional non-limiting examples of satellite image views that may be rendered according to the techniques described herein. Specifically, FIG. 5 shows example satellite image views 500A and 500B, each depicting a 3D satellite model 502. In this example, satellite image view 500A is rendered to simulate satellite illumination using visible-spectrum illumination light. By contrast, satellite image view 500B is rendered to simulate satellite illumination using infrared-spectrum illumination light. In general, the image rendering system may simulate lighting and imaging of the 3D satellite models using any suitable illumination light spectrum, such as visible light, infrared light, ultraviolet light, etc.

In some examples, for one or more satellite image views, the image rendering system may additionally output a configuration map labelling, for each of a plurality of pixels of the satellite image view, identifiers corresponding to different satellite components depicted by the plurality of pixels. For instance, the configuration map may take the form of a segmentation mask that distinguishes different components of the 3D satellite model visible in the satellite image view. In one example scenario, the satellite image views rendered by the image rendering system may be used as training data for training a satellite classification model trained to identify different types of satellites, and/or different types of satellite components visible in images. Thus, a configuration map may be used as labeled ground truth data for training such a classification model, in tandem with the plurality of satellite image views. The configuration map may use any suitable identifiers (e.g., pixel values) to represent any suitable components of the satellite (e.g., the satellite body, solar panels, antennas, and/or any other satellite components).

This is schematically illustrated with respect to FIG. 6, showing another example image rendering system 600. Image rendering system 600 has rendered a satellite image view 602 as discussed above, which includes a plurality of image pixels 604 depicting a 3D satellite model. In this example, the image rendering system also outputs a configuration map 606 including a plurality of pixel component labels 608. These labels indicate, for one or more image pixels in the satellite image view, the type of satellite component (e.g., satellite body, solar panel, antenna) depicted by that pixel. In some examples, a configuration map may be output for each satellite image view rendered by the image rendering system. In other examples, configuration maps may only be output for certain selected satellite image views (e.g., selected an automated system according to suitable selection criteria). A configuration map may be output simultaneously with, subsequently to, or prior to output of a corresponding satellite image view labeled by the configuration map.

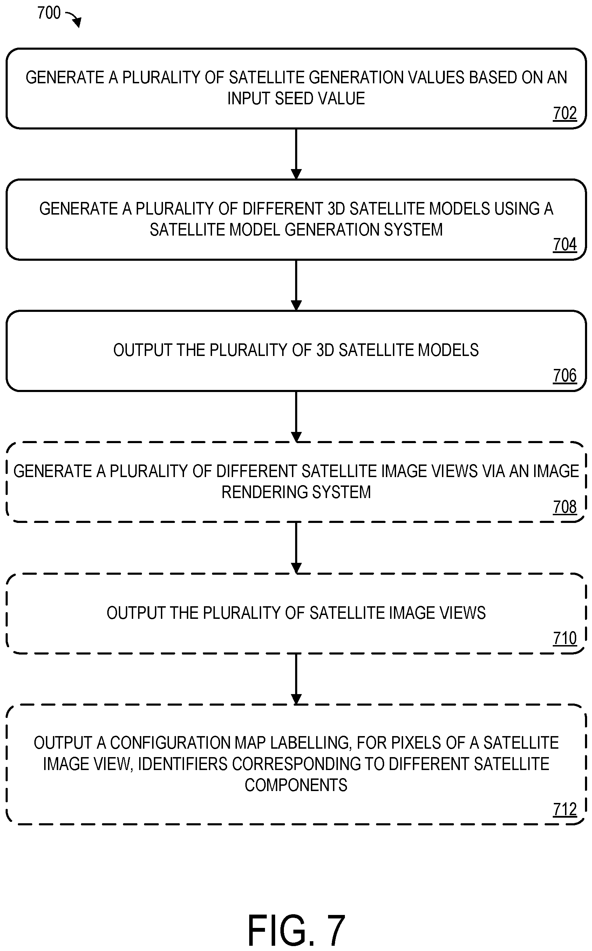

FIG. 7 illustrates an example method 700 for satellite model generation. Steps of method 700 may be initiated, terminated, and/or repeated at any suitable time and in response to any suitable trigger. Method 700 is provided with reference to the example computing systems described herein and shown in FIGS. 1, 2, 4, and 6. In other examples, method 700 may be implemented by any suitable computing system of one or more computing devices. Any computing device performing steps of method 700 may have any suitable form factor, capabilities, and hardware configuration. In some examples, method 700 may be implemented by computing system 800 described below with respect to FIG. 8.

At 702, method 700 includes generating a plurality of satellite generation values based on an input seed value. The input seed value takes any suitable form and has any suitable source. In some examples, the input seed value is input to a pseudo-random number generator to generate the plurality of satellite generation values.

At 704, method 700 includes generating a plurality of different 3D satellite models using a satellite model generation system. As discussed above, the plurality of different 3D satellite models differ according to a plurality of different satellite configuration parameters. The value for each satellite configuration parameter is determined based at least in part on a corresponding satellite generation value, and one or more configuration plausibility constraints.

At 706, method 700 includes outputting the plurality of 3D satellite models. In some examples, once generated, the 3D satellite models are input to an image rendering system that renders a plurality of satellite image views depicting the 3D satellite models. As such, at 708, method 700 optionally includes generating a plurality of different satellite image views via an image rendering system. In some examples, the rendered satellite image views differ according to a plurality of rendering variability parameters, as discussed above.

At 710, method 700 optionally includes outputting the plurality of satellite image views. It will be understood that a satellite image view may be "output" in various suitable ways depending on the implementation. In some embodiments, outputting the satellite image views includes passing the image view to a downstream application (e.g., for training a satellite classification model), transmitting the satellite image view to another computing device, writing the satellite image view to a data file, storing the satellite image view in non-volatile storage of the computing device, and/or storing the satellite image view in an external storage device communicatively coupled with the computing device.

At 712, method 700 optionally includes outputting a configuration map labelling, for pixels of a satellite image view, identifiers corresponding to different satellite components in the satellite image view. As discussed above, the configuration map may take the form of a segmentation mask that distinguishes different components of the 3D satellite model visible in the satellite image view. In one example scenario, the satellite image views rendered by the image rendering system may be used as training data for training a satellite classification model trained to identify different types of satellites, and/or different types of satellite components visible in images. Thus, a configuration map may be used as labeled ground truth data for training such a classification model, in tandem with the plurality of satellite image views.

The methods and processes described herein may be tied to a computing system of one or more computing devices. In particular, such methods and processes may be implemented as an executable computer-application program, a network-accessible computing service, an application-programming interface (API), a library, or a combination of the above and/or other compute resources.

FIG. 8 schematically shows a simplified representation of a computing system 800 configured to provide any to all of the compute functionality described herein. Computing system 800 may take the form of one or more network-accessible devices, personal computers, server computers, mobile computing devices, and/or other computing devices.

Computing system 800 includes a logic subsystem 802 and a storage subsystem 804. Computing system 800 may optionally include a display subsystem 806, input subsystem 808, communication subsystem 810, and/or other subsystems not shown in FIG. 8.

Logic subsystem 802 includes one or more physical devices configured to execute instructions. For example, the logic subsystem may be configured to execute instructions that are part of one or more applications, services, or other logical constructs. The logic subsystem may include one or more hardware processors configured to execute software instructions. Additionally, or alternatively, the logic subsystem may include one or more hardware or firmware devices configured to execute hardware or firmware instructions. Processors of the logic subsystem may be single-core or multi-core, and the instructions executed thereon may be configured for sequential, parallel, and/or distributed processing. Individual components of the logic subsystem optionally may be distributed among two or more separate devices, which may be remotely located and/or configured for coordinated processing. Aspects of the logic subsystem may be virtualized and executed by remotely-accessible, networked computing devices configured in a cloud-computing configuration.

Storage subsystem 804 includes one or more physical devices configured to temporarily and/or permanently hold computer information, such as data and instructions executable by the logic subsystem. When the storage subsystem includes two or more devices, the devices may be collocated and/or remotely located. Storage subsystem 804 may include volatile, nonvolatile, dynamic, static, read/write, read-only, random-access, sequential-access, location-addressable, file-addressable, and/or content-addressable devices. Storage subsystem 804 may include removable and/or built-in devices. When the logic subsystem executes instructions, the state of storage subsystem 804 may be transformed - e.g., to hold different data.

Aspects of logic subsystem 802 and storage subsystem 804 may be integrated together into one or more hardware-logic components. Such hardware-logic components may include program- and application-specific integrated circuits (PASIC / ASICs), program- and application-specific standard products (PSSP / ASSPs), system-on-a-chip (SOC), and complex programmable logic devices (CPLDs), for example.

The logic subsystem and the storage subsystem may cooperate to instantiate one or more logic machines. As used herein, the term "machine" is used to collectively refer to the combination of hardware, firmware, software, instructions, and/or any other components cooperating to provide computer functionality. In other words, "machines" are never abstract ideas and always have a tangible form. A machine may be instantiated by a single computing device, or a machine may include two or more subcomponents instantiated by two or more different computing devices. In some implementations a machine includes a local component (e.g., software application executed by a computer processor) cooperating with a remote component (e.g., cloud computing service provided by a network of server computers). The software and/or other instructions that give a particular machine its functionality may optionally be saved as one or more unexecuted modules on one or more suitable storage devices.

When included, display subsystem 806 may be used to present a visual representation of data held by storage subsystem 804. This visual representation may take the form of a graphical user interface (GUI). Display subsystem 806 may include one or more display devices utilizing virtually any type of technology. In some implementations, display subsystem may include one or more virtual-, augmented-, or mixed reality displays.

When included, input subsystem 808 may comprise or interface with one or more input devices. An input device may include a sensor device or a user input device. Examples of user input devices include a keyboard, mouse, touch screen, or game controller. In some embodiments, the input subsystem may comprise or interface with selected natural user input (NUI) componentry. Such componentry may be integrated or peripheral, and the transduction and/or processing of input actions may be handled on- or off-board. Example NUI componentry may include a microphone for speech and/or voice recognition; an infrared, color, stereoscopic, and/or depth camera for machine vision and/or gesture recognition; a head tracker, eye tracker, accelerometer, and/or gyroscope for motion detection and/or intent recognition.

When included, communication subsystem 810 may be configured to communicatively couple computing system 800 with one or more other computing devices. Communication subsystem 810 may include wired and/or wireless communication devices compatible with one or more different communication protocols. The communication subsystem may be configured for communication via personal-, local- and/or wide-area networks.

This disclosure is presented by way of example and with reference to the associated drawing figures. Components, process steps, and other elements that may be substantially the same in one or more of the figures are identified coordinately and are described with minimal repetition. It will be noted, however, that elements identified coordinately may also differ to some degree. It will be further noted that some figures may be schematic and not drawn to scale. The various drawing scales, aspect ratios, and numbers of components shown in the figures may be purposely distorted to make certain features or relationships easier to see.

Further, the disclosure comprises configurations according to the following examples.

Example 1. A method for satellite model generation, the method comprising: generating a plurality of satellite generation values based on an input seed value; using a satellite model generation system, generating a plurality of different three-dimensional (3D) satellite models, wherein the plurality of different 3D satellite models differ according to a plurality of satellite configuration parameters, and wherein, for each 3D satellite model of the plurality of different 3D satellite models, the plurality of satellite configuration parameters of the 3D satellite model are determined based at least in part on the plurality of satellite generation values and a plurality of configuration plausibility constraints of the satellite model generation system; and outputting the plurality of different three-dimensional (3D) satellite models.

Example 2. The method of example 1, wherein at least one configuration plausibility constraint of the plurality of configuration plausibility constraints defines, for a satellite configuration parameter of the plurality of satellite configuration parameters, a range of permissible values for the satellite configuration parameter.

Example 3. The method of example 1 or 2, wherein at least one configuration plausibility constraint of the plurality of configuration plausibility constraints defines, for a satellite configuration parameter of the plurality of satellite configuration parameters, a probability distribution of values for the satellite configuration parameter.

Example 4. The method of any of examples 1 to 3, wherein at least one configuration plausibility constraint of the plurality of configuration plausibility constraints defines, for a satellite configuration parameter of the plurality of satellite configuration parameters, a maximum ratio difference between the satellite configuration parameter and a second satellite configuration parameter.

Example 5. The method of any of examples 1 to 4, wherein the plurality of configuration plausibility constraints are associated with a first satellite output profile of the satellite model generation system, and wherein the satellite model generation system is switchable between the first satellite output profile and a second satellite output profile associated with a second different plurality of configuration plausibility constraints.

Example 6. The method of any of examples 1 to 5, further comprising automatically generating a plurality of different satellite image views of the plurality of different 3D satellite models via an image rendering system.

Example 7. The method of example 6, wherein each of the plurality of different satellite image views differ according to one or more rendering variability parameters, wherein for each satellite image view of the plurality of different satellite image views, the rendering variability parameters are selected from a pose of a 3D satellite model within the satellite image view, a distance of the 3D satellite model from a virtual camera position, and a backdrop scene in the satellite image view.

Example 8. The method of example 6 or 7, wherein a first satellite image view of the plurality of different satellite image views is rendered to simulate satellite illumination using visible-spectrum illumination light, and wherein a second satellite image view of the plurality of different satellite image views is rendered to simulate satellite illumination using infrared-spectrum illumination light.

Example 9. The method of any of examples 6 to 8, further comprising outputting, for a satellite image view of the plurality of different satellite image views, a configuration map labelling, for each of a plurality of pixels of the satellite image view, identifiers corresponding to different satellite components depicted by the plurality of pixels.

Example 10. The method of any of examples 1 to 9, wherein the plurality of satellite configuration parameters include one or more satellite component parameters, and wherein the satellite component parameters are selected from a shape of a satellite body of the 3D satellite model, a quantity of solar panels for the 3D satellite model, a quantity of antennas for the 3D satellite model, a quantity of thrusters for the 3D satellite model, dimensions for one or more satellite components in the 3D satellite model, a component type for the one or more satellite components in the 3D satellite model, an attachment type for the one or more satellite components in the 3D satellite model, and attachment locations for one or more of the satellite components in the 3D satellite model.

Example 11. The method of any of examples 1 to 10, wherein the plurality of satellite configuration parameters include one or more satellite material parameters, and wherein for a simulated material in the 3D satellite model, the satellite material parameters are selected from reflectivity properties of the simulated material, brightness properties of the simulated material, and thermal properties of the simulated material.

Example 12. The method of any of examples 1 to 11, wherein the plurality of satellite configuration parameters include one or more satellite lighting parameters, and wherein the satellite lighting parameters are selected from a position of a light source relative to the 3D satellite model, an intensity of illumination light provided by the light source, and a uniformity of the illumination light on the 3D satellite model.

Example 13. The method of any of examples 1 to 12, wherein the plurality of satellite configuration parameters include, for each of one or more generic component representations attached to a satellite body in the 3D satellite model, an appearance of a generic component representation and a position of a generic component representation.

Example 14. A computing system, comprising: a logic subsystem; and a storage subsystem holding instructions executable by the logic subsystem to: generate a plurality of satellite generation values based on an input seed value; use a satellite model generation system to generate a plurality of different three-dimensional (3D) satellite models, wherein the plurality of different 3D satellite models differ according to a plurality of satellite configuration parameters, and wherein, for each 3D satellite model of the plurality of different 3D satellite models, the plurality of satellite configuration parameters of the 3D satellite model are determined based at least in part on the plurality of satellite generation values and a plurality of configuration plausibility constraints of the satellite model generation system; and output the plurality of different three-dimensional (3D) satellite models.

Example 15. The computing system of example 14, wherein at least one configuration plausibility constraint of the plurality of configuration plausibility constraints defines, for a satellite configuration parameter of the plurality of satellite configuration parameters, a range of permissible values for the satellite configuration parameter.

Example 16. The computing system of example 14 or 15, wherein at least one configuration plausibility constraint of the plurality of configuration plausibility constraints defines, for a satellite configuration parameter of the plurality of satellite configuration parameters, a probability distribution of values for the satellite configuration parameter.

Example 17. The computing system of any of examples 14 to 16, wherein at least one configuration plausibility constraint of the plurality of configuration plausibility constraints defines, for a satellite configuration parameter of the plurality of satellite configuration parameters, a maximum ratio difference between the satellite configuration parameter and a second satellite configuration parameter.

Example 18. The computing system of any of examples 14 to 17, wherein the plurality of configuration plausibility constraints are associated with a first satellite output profile of the satellite model generation system, and wherein the satellite model generation system is switchable between the first satellite output profile and a second satellite output profile associated with a second different plurality of configuration plausibility constraints.

Example 19. The computing system of any of examples 14 to 18, wherein the instructions are further executable to automatically generate a plurality of different satellite image views of the plurality of different 3D satellite models via an image rendering system of the computing system, wherein each of the plurality of different satellite image views differ according to one or more rendering variability parameters, and wherein for each satellite image view of the plurality of different satellite image views, the rendering variability parameters are selected from a pose of a 3D satellite model within the satellite image view, a distance of the 3D satellite model from a virtual camera position, and a backdrop scene in the satellite image view.

Example 20. A method for satellite model generation, the method comprising: generating a plurality of satellite generation values based on an input seed value; using a satellite model generation system, generating a plurality of different three-dimensional (3D) satellite models, wherein the plurality of different 3D satellite models differ according to a plurality of satellite configuration parameters, and wherein, for each 3D satellite model of the plurality of different 3D satellite models, the plurality of satellite configuration parameters of the 3D satellite model are determined based at least in part on the plurality of satellite generation values and a plurality of configuration plausibility constraints of the satellite model generation system; automatically generating a plurality of different satellite image views of the plurality of different 3D satellite models via an image rendering system; and outputting the plurality of different satellite image views of the plurality of different 3D satellite models.

It will be understood that the configurations and/or approaches described herein are exemplary in nature, and that these specific embodiments or examples are not to be considered in a limiting sense, because numerous variations are possible. The specific routines or methods described herein may represent one or more of any number of processing strategies. As such, various acts illustrated and/or described may be performed in the sequence illustrated and/or described, in other sequences, in parallel, or omitted. Likewise, the order of the above-described processes may be changed.

The subject matter of the present disclosure includes all novel and non-obvious combinations and sub-combinations of the various processes, systems and configurations, and other features, functions, acts, and/or properties disclosed herein, as well as any and all equivalents thereof.

**Claims**

1. A method (700) for satellite model generation, the method comprising:

   generating (702) a plurality of satellite generation values (105, 202) based on an input seed value;
   using a satellite model generation system, generating (704) a plurality of different three-dimensional (3D) satellite models (106, 108A, 108B, 204A, 204B, 204C, 300A, 300B, 310A, 310B, 320A, 320B, 402, 502), wherein the plurality of different 3D satellite models (106, 108A, 108B, 204A, 204B, 204C, 300A, 300B, 310A, 310B, 320A, 320B, 402, 502) differ according to a plurality of satellite configuration parameters (110), and wherein, for each 3D satellite model (106, 108A, 108B, 204A, 204B, 204C, 300A, 300B, 310A, 310B, 320A, 320B, 402, 502) of the plurality of different 3D satellite models (106, 108A, 108B, 204A, 204B, 204C, 300A, 300B, 310A, 310B, 320A, 320B, 402, 502), the plurality of satellite configuration parameters (110) of the 3D satellite model (106, 108A, 108B, 204A, 204B, 204C, 300A, 300B, 310A, 310B, 320A, 320B, 402, 502) are determined based at least in part on the plurality of satellite generation values (105, 202) and a plurality of configuration plausibility constraints (114) of the satellite model generation system (102); and
   outputting (706) the plurality of different three-dimensional (3D) satellite models (106, 108A, 108B, 204A, 204B, 204C, 300A, 300B, 310A, 310B, 320A, 320B, 402, 502).

2. The method of claim 1, wherein at least one configuration plausibility constraint of the plurality of configuration plausibility constraints (114) defines, for a satellite configuration parameter of the plurality of satellite configuration parameters (110), a range of permissible values for the satellite configuration parameter (110).

3. The method of claim 1 or 2, wherein at least one configuration plausibility constraint of the plurality of configuration plausibility constraints (114) defines, for a satellite configuration parameter of the plurality of satellite configuration parameters (110), a probability distribution of values for the satellite configuration parameter (110).

4. The method of any of claims 1 to 3, wherein at least one configuration plausibility constraint of the plurality of configuration plausibility constraints (114) defines, for a satellite configuration parameter of the plurality of satellite configuration parameters (110), a maximum ratio difference between the satellite configuration parameter and a second satellite configuration parameter.

5. The method of any of claims 1 to 4, wherein the plurality of configuration plausibility constraints (114) are associated with a first satellite output profile of the satellite model generation system (102), and wherein the satellite model generation system (102) is switchable between the first satellite output profile and a second satellite output profile associated with a second different plurality of configuration plausibility constraints (114).

6. The method of any of claims 1 to 5, further comprising automatically generating a plurality of different satellite image views (124, 500A, 500B, 602) of the plurality of different 3D satellite models via an image rendering system (122, 400, 600).

7. The method of claim 6, wherein each of the plurality of different satellite image views (124) differ according to one or more rendering variability parameters (128), wherein for each satellite image view of the plurality of different satellite image views (124, 500A, 500B, 602), the rendering variability parameters (128) are selected from a pose of a 3D satellite model (106, 108A, 108B, 204A, 204B, 204C, 300A, 300B, 310A, 310B, 320A, 320B, 402, 502) within the satellite image view, a distance of the 3D satellite model (106, 108A, 108B, 204A, 204B, 204C, 300A, 300B, 310A, 310B, 320A, 320B, 402, 502) from a virtual camera position, and a backdrop scene in the satellite image view (124).

8. The method of claim 6 or 7, wherein a first satellite image view of the plurality of different satellite image views (124, 500A, 500B, 602) is rendered to simulate satellite illumination using visible-spectrum illumination light, and wherein a second satellite image view of the plurality of different satellite image views (124, 500A, 500B, 602) is rendered to simulate satellite illumination using infrared-spectrum illumination light.

9. The method of any of claims 6 to 8, further comprising outputting, for a satellite image view of the plurality of different satellite image views (124, 500A, 500B, 602), a configuration map (606) labelling, for each of a plurality of pixels of the satellite image view (124, 500A, 500B, 602), identifiers corresponding to different satellite components depicted by the plurality of pixels.

10. The method of any of claims 1 to 9, wherein the plurality of satellite configuration parameters include one or more satellite component parameters (110), and wherein the satellite component parameters are selected from a shape of a satellite body (302A, 302B, 312A, 312B, 322A, 322B ) of the 3D satellite model (106, 108A, 108B, 204A, 204B, 204C, 300A, 300B, 310A, 310B, 320A, 320B, 402, 502), a quantity of solar panels (304A, 304B, 314A, 314B, 324A, 324B) for the 3D satellite model, a quantity of antennas (306A, 306B, 326A, 326B) for the 3D satellite model, a quantity of thrusters (316A, 316B) for the 3D satellite model, dimensions for one or more satellite components in the 3D satellite model, a component type for the one or more satellite components in the 3D satellite model, an attachment type for the one or more satellite components in the 3D satellite model, and attachment locations for one or more of the satellite components in the 3D satellite model.

11. The method of any of claims 1 to 10, wherein the plurality of satellite configuration parameters (110) include one or more satellite material parameters, and wherein for a simulated material in the 3D satellite model (106, 108A, 108B, 204A, 204B, 204C, 300A, 300B, 310A, 310B, 320A, 320B, 402, 502), the satellite material parameters are selected from reflectivity properties of the simulated material, brightness properties of the simulated material, and thermal properties of the simulated material.

12. The method of any of claims 1 to 11, wherein the plurality of satellite configuration parameters (110) include one or more satellite lighting parameters, and wherein the satellite lighting parameters are selected from a position of a light source relative to the 3D satellite model (106, 108A, 108B, 204A, 204B, 204C, 300A, 300B, 310A, 310B, 320A, 320B, 402, 502), an intensity of illumination light provided by the light source, and a uniformity of the illumination light on the 3D satellite model.

13. The method of any of claims 1 to 12, wherein the plurality of satellite configuration parameters (110) include, for each of one or more generic component representations attached to a satellite body (302A, 302B, 312A, 312B, 322A, 322B ) in the 3D satellite model (106, 108A, 108B, 204A, 204B, 204C, 300A, 300B, 310A, 310B, 320A, 320B, 402, 502), an appearance of a generic component representation and a position of a generic component representation.

14. A computing system (102), comprising:

a logic subsystem (802); and
a storage subsystem (804) holding instructions executable by the logic subsystem (802) to:

generate a plurality of satellite generation values (105, 202) based on an input seed value;

use a satellite model generation system (102) to generate a plurality of different three-dimensional (3D) satellite models (106, 108A, 108B, 204A, 204B, 204C, 300A, 300B, 310A, 310B, 320A, 320B, 402, 502), wherein the plurality of different 3D satellite models (106, 108A, 108B, 204A, 204B, 204C, 300A, 300B, 310A, 310B, 320A, 320B, 402, 502) differ according to a plurality of satellite configuration parameters (110), and wherein, for each 3D satellite model of the plurality of different 3D satellite models (106, 108A, 108B, 204A, 204B, 204C, 300A, 300B, 310A, 310B, 320A, 320B, 402, 502), the plurality of satellite configuration parameters (110) of the 3D satellite model (106, 108A, 108B, 204A, 204B, 204C, 300A, 300B, 310A, 310B, 320A, 320B, 402, 502) are determined based at least in part on the plurality of satellite generation values (105, 202) and a plurality of configuration plausibility constraints (120) of the satellite model generation system (102); and

output the plurality of different three-dimensional (3D) satellite models (106, 108A, 108B, 204A, 204B, 204C, 300A, 300B, 310A, 310B, 320A, 320B, 402, 502).

15. A method (700) for satellite model generation, the method comprising:

generating (702) a plurality of satellite generation values (105, 202) based on an input seed value;

using a satellite model generation system, generating (704) a plurality of different three-dimensional (3D) satellite models (106, 108A, 108B, 204A, 204B, 204C, 300A, 300B, 310A, 310B, 320A, 320B, 402, 502), wherein the plurality of different 3D satellite models (106, 108A, 108B, 204A, 204B, 204C, 300A, 300B, 310A, 310B, 320A, 320B, 402, 502) differ according to a plurality of satellite configuration parameters (110), and wherein, for each 3D satellite model of the plurality of different 3D satellite models (106, 108A, 108B, 204A, 204B, 204C, 300A, 300B, 310A, 310B, 320A, 320B, 402, 502), the plurality of satellite configuration parameters (110) of the 3D satellite model are determined based at least in part on the plurality of satellite generation values (105, 202) and a plurality of configuration plausibility constraints (114) of the satellite model generation system (102);

automatically generating a plurality of different satellite image views (124, 500A, 500B, 602) of the plurality of different 3D satellite models (106, 108A, 108B, 204A, 204B, 204C, 300A, 300B, 310A, 310B, 320A, 320B, 402, 502) via an image rendering system (122, 400, 600); and

outputting the plurality of different satellite image views (124, 500A, 500B, 602) of the plurality of different 3D satellite models (106, 108A, 108B, 204A, 204B, 204C, 300A, 300B, 310A, 310B, 320A, 320B, 402, 502).

INPUT SEED VALUE 104

COMPUTING SYSTEM 100

PSEUDO-RANDOM NUMBER GENERATOR 103 → SATELLITE GENERATION VALUES 105

SATELLITE MODEL GENERATION SYSTEM 102

CONFIG. PARAMETERS 110
- COMPONENT PARAMETER 112A
- MATERIAL PARAMETER 112B
- LIGHTING PARAMETER 112C

PLAUSIBILITY CONSTRAINTS 114
- RANGE CONSTRAINT 116A
- PROBABILITY CONSTRAINT 116B
- RATIO CONSTRAINT 116C

OUTPUT PROFILE 118A

2ND OUTPUT PROFILE 118B ↔ 2nd CONSTRAINT SET 120

3D SATELLITE MODELS 106
- SATELLITE MODEL 108A
- SATELLITE MODEL 108B ●●●

IMAGE RENDERING SYSTEM 122
- RENDERING VARIABILITY PARAMETERS 128

SATELLITE IMAGE VIEWS 124
- IMAGE VIEW 126A
- IMAGE VIEW 126B ●●●

FIG. 1

SATELLITE GENERATION VALUES
202

SATELLITE MODEL
GENERATION SYSTEM 200

3D SATELLITE MODEL 204A

3D SATELLITE MODEL 204B

3D SATELLITE MODEL 204C

# FIG. 2

FIG. 3A

FIG. 3B

FIG. 3C

EP 4 632 681 A1

FIG. 4

500A

SATELLITE IMAGE VIEW (VIS LIGHT)

502

500B

SATELLITE IMAGE VIEW (IR LIGHT)

502

FIG. 5

IMAGE RENDERING SYSTEM 600

SATELLITE IMAGE VIEW 602

IMAGE PIXELS 604

CONFIGURATION MAP 606

PIXEL COMPONENT LABELS 608

FIG. 6

700

GENERATE A PLURALITY OF SATELLITE GENERATION VALUES BASED ON AN INPUT SEED VALUE
702

GENERATE A PLURALITY OF DIFFERENT 3D SATELLITE MODELS USING A SATELLITE MODEL GENERATION SYSTEM
704

OUTPUT THE PLURALITY OF 3D SATELLITE MODELS
706

GENERATE A PLURALITY OF DIFFERENT SATELLITE IMAGE VIEWS VIA AN IMAGE RENDERING SYSTEM
708

OUTPUT THE PLURALITY OF SATELLITE IMAGE VIEWS
710

OUTPUT A CONFIGURATION MAP LABELLING, FOR PIXELS OF A SATELLITE IMAGE VIEW, IDENTIFIERS CORRESPONDING TO DIFFERENT SATELLITE COMPONENTS
712

FIG. 7

COMPUTING SYSTEM 800

LOGIC SUBSYSTEM 802

STORAGE SUBSYSTEM 804

DISPLAY SUBSYSTEM 806

INPUT SUBSYSTEM 808

COMMUNICATION SUBSYSTEM 810

# FIG. 8

| | Europäisches Patentamt European Patent Office Office européen des brevets | **EUROPEAN SEARCH REPORT** | **Application Number** EP 25 16 3424 |
|---|---|---|---|

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | Anonymous: "Random generator for spaceships", www.ship.shapewright.com/, 2 November 2011 (2011-11-02), XP093288902, Retrieved from the Internet: URL:https://web.archive.org/web/2011110200 2751/https://ship.shapewright.com/ * the whole document * | 1-15 | INV. G06T15/20 G06T17/00 |
| X | Anonymous: "A cool tool to generate random 3D spaceships for your universe. : worldbuilding", , 24 October 2017 (2017-10-24), XP093288848, Retrieved from the Internet: URL:https://web.archive.org/web/2017102413 5930/https://www.reddit.com/r/worldbuildin g/comments/12rurl/a_cool_tool_to_generate_ random_3d_spaceships_for/ * the whole document * | 1-15 | |
| | | | TECHNICAL FIELDS SEARCHED (IPC) G06T |

The present search report has been drawn up for all claims

| Place of search | Date of completion of the search | Examiner |
|---|---|---|
| Berlin | 24 June 2025 | Gao, Miao |